Europäisches Patentamt

European Patent Office

Office européen des brevets

(11) Publication number: **0 162 307**

**A2**

(12) # EUROPEAN PATENT APPLICATION

(21) Application number: **85104850.4**

(22) Date of filing: **22.04.85**

(51) Int. Cl.⁴: **H 01 L 27/14**
**H 04 N 3/15**

(30) Priority: **24.04.84 JP 81120/84**
**27.06.84 JP 131052/84**

(43) Date of publication of application:
**27.11.85 Bulletin 85/48**

(84) Designated Contracting States:
**DE FR GB**

(71) Applicant: **HITACHI, LTD.**
**6, Kanda Surugadai 4-chome Chiyoda-ku**
**Tokyo 100(JP)**

(72) Inventor: **Matsuzaki, Eiji**
**Keimei-ryo Maioka-cho 850 Totsuka-ku**
**Yokohama-shi Kanagawa-ken(JP)**

(72) Inventor: **Yoritomi, Yoshifumi**
**9-202, Noba-cho 638 Kounan-ku**
**Yokohama-shi Kanagawa-ken(JP)**

(72) Inventor: **Kenmotsu, Akihiro**
**Kameino 866-15**
**Fujisawa-shi Kanagawa-ken(JP)**

(74) Representative: **Altenburg, Udo, Dipl.-Phys. et al,**
**Patent- und Rechtsanwälte**
**Bardehle-Pagenberg-Dost-Altenburg & Partner Postfach**
**86 06 20**
**D-8000 München 86(DE)**

(54) **Image sensor and method of manufacturing same.**

(57) An image sensor in which a valve metal or nitride thereof is employed as material for the electrode wiring of a metal film, and a part of the metal film wiring is oxidized to form a dielectric film of a charge storage capacitor, thereby providing a charge storage capacitor which has the high quality and enables high production yield. By forming a thin film photo diode on the dielectric film, the number of elements having a sandwich structure is reduced by half and the production yield is increased correspondingly.

*FIG. 2*

EP 0 162 307 A2

Hitachi, Ltd.

**0162307**

April 22, 1985
H 6227-EP

1. Title of the Invention

IMAGE SENSOR AND METHOD OF MANUFACTURING SAME

2. Background of the Invention

a. Field of the Invention

The present invention relates to an image sensor and a manufacturing method of same, which sensor is used in character/picture input devices such as facsimile or laser recording devices.

b. Description of the Prior Art

Heretofore, CCD type image sensors, MOS type image sensors, etc. have been employed as image sensors for reading an image of the document. Any of those image sensors is formed on a silicon chip using LSI technology and the element itself has a very small size. Accordingly, reading of the document with such image sensors requires a combination of optical systems, as well the resulting highly skilled adjustment of the optical systems. This has the disadvantage of causing distortion in the image and enlarging the size of the entire device.

To overcome such disadvantages, a full-size image sensor was devised which included a plurality of light receiving elements, each composed of a thin film, formed on the same single substrate. Because it did not operate in the storage mode, however, that image sensor had low effective sensitivity and could not carry out reading at a high speed.

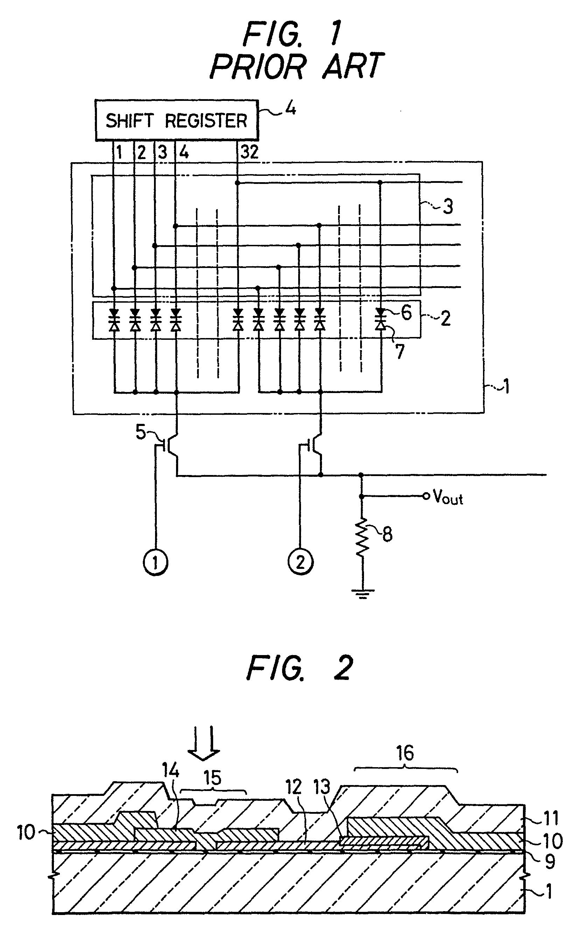

From this reason, there has been devised another full-size image sensor in which a plurality of elements, each comprising a thin film photo diode and a thin film blocking diode serially connected with opposite polarities relative to each other, are arrayed to permit operation in the storage mode. Furthermore, by connecting the individual elements and a drive circuit such as a shift register in the form of matrix wiring, it has also become possible to reduce the number of input and output terminals as well as the number of special purpose IC's and shift registers loaded thereon. One example of such arrangement is shown in Fig. 1 (see Japanese Patent Laid-Open No. 57-5371). In the figure, designated at 1 is a sensor substrate, 2 a set of thin film elements, 3 a matrix wiring, 4 a shift register, 5 a MOS switch, 6 a blocking diode, 7 a photo diode, and at 8 is a load resistor. This arrangement has succeeded in providing characteristics reasonably satisfactory. In a full-size image sensor, however, the sensor array must be as large as the longest dimension (210 mm for A4). No such array has been manufactured yet. In the current situation, it is thus impossible to manufacture full-size image sensors economically on mass production basis.

- 3 -                                    0162307

3. Summary of the Invention

An object of the present invention is to provide the construction of an image sensor and a manufacturing process of same, which can eliminate the above-mentioned disadvantages in the prior art and by which full-size image sensors can be mass-produced.

With a view of improving the lower production yield of charge storage capacitors which is one of the problems encountered in attempting to increase the length of an image sensor composed of charge storage capacitors and of thin film elements each having a function of photoelectric conversion, the present invention is intended for an image sensor and a manufacturing method of same in which, based on the fact that oxidization of valve metals represented by Ta and nitrides thereof produces a dielectric film formed of a high-quality oxide film free of pin holes, at least one of valve metals and nitrides thereof is used as material for the electrode wiring of metal film and partially oxidized to form dielectric film for the charge storage capacitors, thereby providing high-quality charge storage capacitors with increased production yield.

Further, the present invention is intended to achieve the following improvement by making use of the aforesaid dielectric film. More specifically, thin film photo

- 4 -                              0162307

diodes and thin blocking diodes are charge storage capacitors, which serve as basic elements of an image sensor
capable of operating in the charge storage mode, have
basically a sandwich structure where each element is
held between two electrodes.  This structure makes it
difficult to form the respective elements free of any
defect over a large area with a high yield.  Since this
defect prevents realization of a longer image sensor,
the invention features the improvement that, based on
the fact that oxidization of valve metals represented by
Ta and nitrides thereof produces an oxide film theoretically free of any pin holes, at least one of valve metals
and nitrides thereof is used as material for the electrode wiring and partially oxidized to form a dielectric
film for each of the charge storage capacitors, and a
thin film photodiode is formed thereon, thereby reducing
the number of elements having the sandwich structure by
half; hence, increasing the production yield so as to
realize an longer image sensor.

4.  Brief Description of the DRawings

Fig. 1 is a circuit diagram of a conventional full-
scaled image sensor;

Fig. 2 is a sectional view showing a first embodiment of an image sensor according to the present invention;

Fig. 3 is an equivalent circuit diagram showing operation of the image sensor of Fig. 2;

Fig. 4 is a sectional view showing a second embodiment of the image sensor according to the present invention;

Fig. 5 is an equivalent circuit diagram showing operation of the image sensor of Fig. 4, and

Figs. 6, 7 and 8 are longitudinal sectional views showing third, fourth and fifth embodiments of the image sensor according to the present invention, respectively.

5. Detailed Description of Preferred Embodiments

In the following, preferred embodiments of the present invention will be described with reference to Figs. 2 through 8.

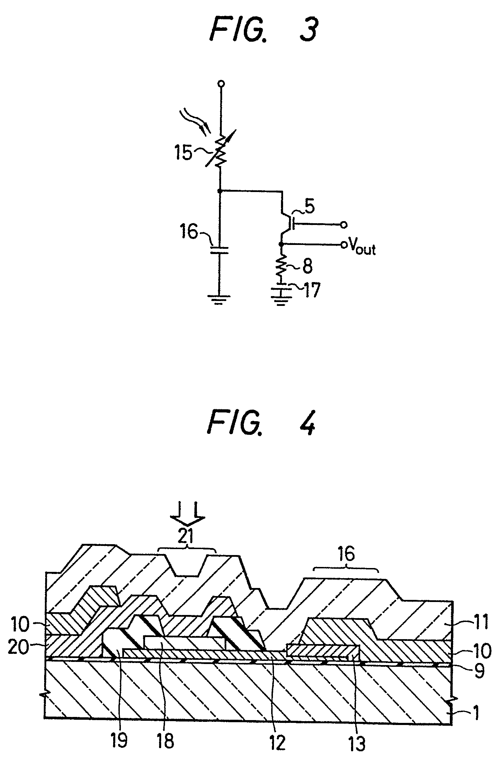

Fig. 2 is a sectional view showing a first embodiment of an image sensor and a manufacturing method of same according to the present invention, and Fig. 3 is an equivalent circuit diagram showing operation of the image sensor. Referring to Figs. 2 and 3, designated at 1 is a glass substrate (e.g., #7059 from Corning Glass Works Co.), 9 a Ta (tantalum) thermal oxide film for protecting the glass substrate 1 in the photo etching process, 10 a metal film wiring (or electrode wiring), 11 a light transparent protective film (protective layer) of $Si_3N_4$ or so for protecting thin film elements, 12 a valve metal film wiring (or electrode wiring) formed of at least one of valve metals represented by Ta and nitrides thereof such as a tantalum nitride film, 13 a dielectric film (dielectric layer) for a charge storage capacitor formed of a valve metal oxide film, which is obtained by oxidizing the same valve metal film as that of the wiring 12 such as a tantalum nitride film, and at 14 is a photoconductor film (photoconductor layer) of photoconductive element formed of an amorphous silicon film containing therein hydrogen. In this connection, designated at 15 is a thin film photoconductive element (or photoelectric conversion element) composed of the valve metal film wiring 12, the photoconductor layer 14 and the metal film wiring 10, while at 16 is a charge storage capacitor composed of the valve metal film wiring 12, the dielectric layer 13 and the metal film wiring 10, the photoconductive element 15 and the charge storage capacitor 16 being formed on the valve metal film wiring 12 separately from each other and serially connected to each other.

Furthermore, in Fig. 3 designated at 5 is a switching transistor (FET) for transferring electric charges stored in the charge storage capacitor 16 to a load resistor, 8 a load resistor for reading the transferred electric charges, and at 17 is a power supply used for

- 7 -

0162307

charging the charge storage capacitor 16. It is to be noted that, by letting the photoconductive element 15 and teh charge storage capacitor 16 to be connected serially to form a thin film element as a single component and arranging a plurality of such components into a predetermined array, a full-length image sensor can be made.

Operation of this construction will now be described. First, with no light irradiating the photoconductive element 15, the switching transistor 5 is turned to a conducted state to charge the charge storage capacitor 16 using the power supply 17. Then, the transistor 5 is made a non-conductive and light is irradiated into the photoconductive element 15, thereby to discharge the electric charges stored in the charge storage capacitor 16 through the photoconductive element 15. After that, irradiation of light onto the photoconductive element 15 is stopped and the switching transistor 5 is made to conduct again so that the charge storage capacitor 16 is then charged, to read the charging current at that time as a signal current through the load resistor 8. At this time, the amount of signal electric charges stored in the charge storage capacitor 16 is determined by the resistance value of the photoconductive element 15 at the time when the light is irradiated, a capacitance value and a charging (storing) time of the charge storage capacitor 16, etc., while the speed of reading signals through the load resistor 8 is determined by the capacitance value of the charge storage capacitor 16 and the resistance value of the load resistor 8.

According to this embodiment, the charge storage capacitor 16 has the dielectric film (dielectric layer) 13 which is formed of a valve metal oxide film resulting from oxidizing the same valve metal film, for example, a tantalum nitride film, as that of the valve metal film wiring (electrode wiring) 12, there can be obtained a high-quality charge storage capacitor which as a remarkably small leak current as compared with the conventional one in which a dielectric film such as $Ta_2O_5$ or $SiO_2$ is formed by making use of sputtering or other techniques, and which exhibits a very small probability of generating pin holes. Further, the photoconductive element (photoelectric conversion element) 15 has a planar structure, this part also offers a high production yield. Therefore, by letting the photoconductive element 15 and the charge storage capacitor 16 combine to form a single component and arranging a plurality of such components into a predetermined array, it becomes possible to realize elongate image sensors with a high yield. The image sensor thus constructed permits high-speed reading because it is capable of operating in the storage mode.

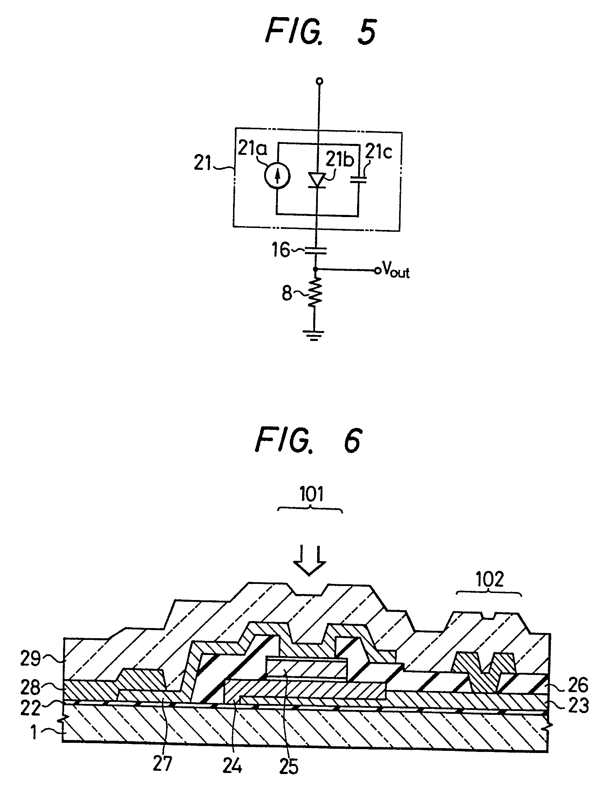

Fig. 4 is a sectional view showing a second embodiment of the image sensor and a manufacturing method of same according to the present invention, and Fig. 5 is an equivalent circuit diagram showing operation thereof. Referring to Figs. 4 and 5, the same reference numerals as those in Figs. 2 and 3 designate the same or corresponding parts and, in addition, designated at 18 an amorphous silicon thin film constituting a Pin photo diode, 19 an interlayer insulating film and at 20 is a transparent conductive film. In this connection, designated at 21 is a Pin photo diode (or amorphous silicon photo diode) composed of the valve metal film wiring (electrode wiring) 12, the amorphous silicon thin film 18 and the transparent conductive film 20, the Pin photo diode 21 and the charge storage capacitor 16 being formed on the valve metal film wiring 12 separately from each other and serially connected to each other. By letting those serially connected Pin photo diode 21 and charge storage capacitor 16 to form a thin film element as a single component and arranging a plurality of such components into a predetermined array, it becomes possible to manufacture a full-length image sensor. It is to be noted that, as shown in Fig. 5, the equivalent circuit of the Pin photo diode 21 can be represented by a parallel circuit which comprises a light current source 21a, a diode 21b and a capacitor 21c.

016230

Operation of this construction will now be described. First, with no light irradiating the photo diode 21, a forward current is caused to flow from a power supply (not shown) to charge the charge storage capacitor 16. Then, a light is irradiated onto the photo diode 21 thereby to discharge the electric charges stored in the charge storage capacitor 16 in the form of a photo current having the opposite polarity. After that, irradiation of light into the photo diode 21 is stopped and a forward current is caused to flow through the photo diode 21 from the power supply so that the charge storage capacitor 16 is charged again, to read the charging current at that time as a signal current through the load resistor 8. At this time, since the electric charges are stored in the charge storage capacitor by utilizing backward characteristics of the Pin photo diode, the leak current becomes smaller and the S/N ratio is improved. Further, utilization of photocurrent due to the photovoltatic effect permits high-speed reading.

According to this embodiment, since on the valve metal film wiring 12 formed of such as a tantalum nitride film there are separately formed and serially connected the Pin photo diode 21 including the amorphous silicon thin film 18, the transparent conductive film 20, etc. and the charge storage capacitor 16 including the

- 11 -

0162307

dielectric layer 13 formed of an oxide film of the same valve metal film as that of the wiring 12 and the metal film wiring 10, a similar effect to that in the embodiment of Fig. 2 is obtained for the charge storage capacitor 16, whereby the production yield of the Pin photo diode 21 is increased. Thus, by letting the serially connected Pin photo diode 21 and charge storage capacitor 16 form a thin film element as a single component and arranging a plurality of such components into a predetermined array, an elongate image sensor of this type can be manufactured with the higher yield.

The process for a manufacturing method of the image sensor of Fig. 4 will now be described by way of example. First, a Ta film is formed on the glass substrate 1 and thermally oxidized to form the Ta thermal oxide film 9 made of tantalum pentaoxide for protecting the glass substrate. The reactive sputtering technique is used to produce thereon a valve metal film, e.g., a tantalum nitride film, which is then photo-etched to form the valve metal film wiring 12 of a predetermined electrode pattern. Subsequently, a part of the electrode pattern of the valve metal film wiring 12 is further patterned by making use of a photo resist oxidized by anode oxidization to form the dielectric film 13 of the charge storage capacitor 16. Next, on another part of the

0162307

electrode pattern of the valve metal film wiring 12, n-, i-, and p-layers of an amorphous silicon film having a predetermined thickness are laminated in this order using a plasma CVD technique, and then subjected to photo processing and dry etching to form an amorphous silicon thin film 18, having a predetermined pattern, of the Pin photo diode 21 which film 18 is separated from but serially connected to the dielectric film 13. The sputtering technique is used to form thereon a silicon oxide film, which is then photo-etched to form an interlayer insulating film 19 of a predetermined pattern. Furthermore, a transparent conductive film formed of an ITO film, for example, is produced by making use of the sputtering technique and photo-etched to form a transparent conductive film 20 of a predetermined electrode pattern. Then, a metal film such as $A\ell$ is produced thereon by making use of the sputtering technique and also photo-etched to form the metal film wiring (or electrode wiring) 10 of a predetermined pattern. Finally, the plasma CVD technique is used to form the light transparent protective film 11 such as a silicon nitride film $(Si_3N_4)$.

According to the process for a manufacturing method of the image sensor of this embodiment, the effect of the present invention in enhancing the quality of charge storage capacitors to permit manufacture of elongate image sensors with a high yield can be successfully materialized by converting a part of the valve metal film wiring 12 formed of such as a tantalum nitride film to an oxide with anode oxidization, etc. thereby to form the dielectric film 13 of the charge storage capacitor 16. It is also possible to optionally change the dielectric constant, thickness, pattern shape and its size of the dielectric film 13, thus resulting in a high degree of freedom in design. It is to be noted that a substantially equivalent effect can be likewise obtained by employing, in addition to a tantalum nitride, at least one of similar Sb, Bi, Hf, Nb, Ti, W, Zr and nitrides thereof as material of the valve metal film wiring (or electrode wiring) 12. As a method of oxidizing the above material, plasma oxidization or thermal oxidization may be also used in place of anode oxidization. Furthermore, because many of materials of the valve metal film wiring 12 have great specific resistance, it is effective in reducing the resistance value of the electrode wiring for the valve metal film wiring 12 to have a two or more multi-layered film structure composed of a valve metal film made of the above-stated material and at least one another metal film having greater conductivity than the material of the former. In addition, the amorphous silicon film 14 and the amorphous silicon thin film 18 of a photoelectric conversion element such as the aforesaid photoconductive element 15 or the Pin photo diode 21 can be consisted of amorphous silicon containing at least one chemical element of H, O, halogens, N, P, B, Aℓ and As.

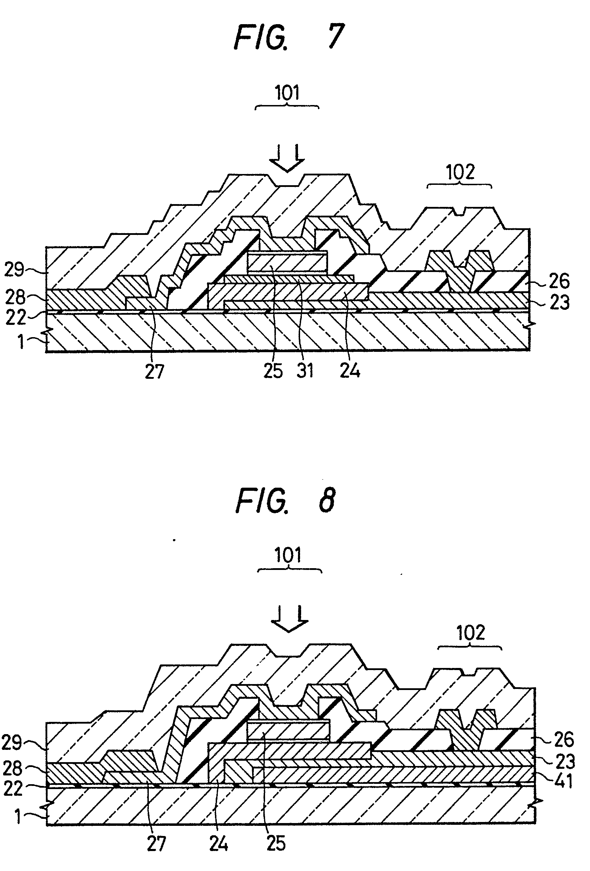

Hereinafter, third, fourth and fifth embodiments of the present invention will be described with reference to Figs. 6, 7 and 8. In each of these figures, designated at 1 is a glass substrate, 22 a protective layer for the glass substrate (e.g., tantalum thermal oxide film), 23 a tantalum nitride film wiring, 24 a dielectric film formed of a tantalum oxide film which is obtained by oxidizing the tantalum nitride, 25 a PIN photo diode formed of an amorphous silicon film, 26 an interlayer insulating film formed of a silicon oxide film, 27 a transparent conductive film (e.g., ITO film or oxide film of In/Sn alloy), 28 a metal wiring consisted of such as Aℓ, 29 a protective film (e.g., silicon nitride film), 101 a photo sensor section, and at 102 is a matrix wiring section. Further, designated at 31 in Fig. 7 is a metal film such as a Cr film and at 41 in Fig. 8 is a film of high-conductivity metal (e.g., Aℓ or Cr) which is interposed in order to reduce the resistance of the lower wiring.

- 15 -                                    0162307

Out of Figs. 6, 7 and 8, Fig. 6 shows a basic form of the improved embodiment. Fig. 7 shows an example of modified construction in which the metal film 31 such as a Cr film is interposed to enhance fixation of an electrode film of the charge storage capacitor as well as adhesive degree between the tantalum oxide film and the amorphous silicon film. Fig. 8 shows another example of modified construction in which, because a tantalum nitride film has large resistivity of 200 $\mu\Omega$ cm, the high-conductivity metal film 41 such as a Cr film having resistivity of about 50 $\mu\Omega$ cm to reduce the resistance of the electrodes and wiring. The particular features of the improved invention are respectively embodied in the construction of those layers designated at 23, 24, 25 and 27 in Fig. 7, the construction of those layers designated at 23, 24, 31, 25 and 27 in Fig. 8, and the construction of those layers designated at 41, 23, 24, 25 and 27.

Operation of the image sensor embodying the improved invention will be described below. Equivalent circuits of the embodiments shown in Figs. 6, 7 and 8 are all similar to that shown in Fig. 5. Referring to Fig. 5, designated at 21 is a thin film photo diode constituted by the PIN photo diode 25 formed of an amorphous silicon film, 16 a charge storage capacitor constituted by the tantalum oxide film, and at 8 is a load resistor for reading. First, with no irradiation of light, a forward current is caused to flow through the thin film photo diode 21 to charge the charge storage capacitor 16. Then, upon irradiation of light, a photocurrent is generated in the photo diode, so that the electric charges stored in the charge storage capacitor 16 is discharged. Thereafter, irradiation of light is stopped and a forward current is caused to flow through the photo diode once again to recharge the charge storage capacitor 16. The charging current at that time is read as a signal. In this manner, the image sensor operates in the storage mode and it is capable of high-speed reading. In practice, the image sensor comprising a plurality of the foregoing unit elements properly arrayed and connected in the form of matrix wiring is able to read a document of A4 size at a speed of less than 5 ms/line with a resolution of 8 dot/mm.

A manufacturing method of the image sensor according to the improved invention will now be described. By way of example, there will be explained the manufacturing process for the embodiment shown in Fig. 6. First, a tantalum film is formed on the glass substrate 1 and thermally oxidized to form the protective layer 22 made of a tantalum pentaoxide film for protecting the glass substrate. The reactive sputtering technique is used to produce thereon a tantalum nitride film, which is then photo-etched to the tantalum nitride film wiring 23 of a predetermined electrode/wiring pattern. Subsequently, a part of the electrode pattern is further patterned by making use of a photo resist or so and oxidized with anode oxidization to form the dielectric film 24 of the charge storage capacitor. Next, using the plasma CVD technique, a gas mixture of $SiH_4$, $H_2$ and $PH_3$ is decomposed to deposit an n-type amorphous silicon film, a gas mixture of $SiH_4$ and $H_2$ is decomposed to deposit an amorphous silicon film, and a gas mixture of $SiH_4$, $H_2$ and $B_2H_6$ is decomposed to deposit a p-type amorphous silicon film in this order, each of those films having a predetermined thickness. Subsequently, a predetermined pattern is formed with a photo process and dry etching to provide the PIN photo diode 25. Another predetermined pattern is formed thereon with sputtering to provide the interlayer insulating film 26. Then, an ITO film is deposited with sputtering and photo-etched into a predetermined pattern thereby to provide the transparent conductive film 27. Next, an Aℓ film is produced with sputtering and patterned with photo-etching to form the metal wiring 28. Further, using the plasma CVD technique, a gas mixture of $SiH_4$, $NH_3$ and $N_2$ is decomposed and made to react so as to deposit a silicon nitride film, thereby providing a protective film 29.

In the above-mentioned manufacturing process, it is possible that the dielectric film 24 might be formed by utilizing an amorphous silicon film of high resistance, or by depositing a silicon oxide film, silicon nitride film, titanium oxide film or the like. However, in case of using an amorphous silicon film the leak current becomes large because it is not an insulator, whereas in case of depositing a dielectric film the film thickness must be great; hence, it is difficult to form such a film with a high yield. The effect of the present invention in reducing the number of detects in each element of the sandwich structure is attributable to the fact that a part of the tantalum nitride film serving as an electrode is converted to an oxide by making use of anode oxidization thereby to provide the dielectric film. Furthermore, the dielectric film thus obtained can be desirously changed in its dielectric constant, thickness and electrode area, thus resulting in a high degree of freedom in design. In order to achieve such an effect, the electrode material may be formed of, in addition to a tantalum nitride, at least one of Sb, Bi, Hf, Nb, Ti, W, Zr and nitrides thereof which are similar thereto in properties. Further, an oxidizing means is not limited to anode oxidization, and plasma oxidization, thermal oxidization, etc. can be employed instead so long as no adverse effects are caused.

In case of the structure in which a thin film photo diode and a thin film blocking diode are reverse-serially connected to each other, the element may be broken sometimes due to electrostatic charges while manufacturing. Also, in case of the planar structure in which a thin film photo diode and a charge storage capacitor are formed separately, the photo diode may sometimes be electrostatically broken. Even against such electrostatic breakage, the element embodying the improved invention has strong resistance. This is believed to result from the fact that the voltage caused by electrostatic charges is distributed by the charge storage capacitor in the element according to the improved invention.

Furthermore, although the thin film photo diode is constituted by an amorphous silicon film in the foregoing embodiment, the material of the thin film photo diode is not limited thereto CdS - CdTe - Te, ZnS - ZnTe, CdS - CdSe, CdSe - CdTe, As - Se - Te, Se - Te, CdS - CdTe - $As_2Se_3$, etc. may be employed instead.

As described herein above, the present invention is able to increase the production yield of the respective elements and manufacture a full-length image sensor as a result of reducing the number of elements having the sandwich structure and devising the method of forming the construction of a photo sensor section and a dielectric film.

According to the present invention, since the number of defects occurring in the sandwich structure elements can be also reduced, it becomes possible to form, with a high yield, the respective elements of an image sensor capable of operating in the storage mode and to provide a full-sized or reduction-sized elongate image sensor capable of high-speed reading.

C L A I M S

1.    An image sensor comprising; a substrate; a metal film wiring formed on said substrate; a thin film element for photoelectric conversion formed on a part said metal film wiring; and a charge storage dielectric layer formed by oxidizing a part of said metal film wiring in a position different from one where said thin film element is formed on said metal film wiring.

2.    An image sensor according to claim 1, wherein said metal film wiring is consisted of at least one of Sb, Bi, Hf, Nb, Ta, Ti, W, Zr and nitrides thereof.

3.    An image sensor according to claim 2, wherein said metal film wiring is composed of a multi-layered thin film comprising said metal film and another metal film which has higher conductivity than said metal film.

4.    An image sensor according to claim 1, wherein said thin film element endowed with a function of photoelectric conversion includes an amorphous silicon film containing at least one chemical element of H, O, halogens, N, P, B, Aℓ and As.

5.    A manufacturing method of an image sensor comprising the steps of preparing a substrate; forming a metal film wiring on said substrate; forming a thin film element for photoelectric conversion on a part of said metal film wiring; and forming a charge storage dielectric layer by oxidizing a part of said metal film wiring in a position different from one where said thin film element is formed on said metal film wiring.

6.   An image sensor having the structure in which on a part of a metal film wiring provided on a substrate is formed an oxide film of the metal used for said metal film wiring, and a thin film photo diode and a transparent conductive film are laminated in this order on said metal oxide film.

7.   An image sensor according to claim 6, wherein said sensor has the structure in which, after forming a metal film on said metal oxide film, said thin film photo diode and said transparent conductive film are laminated thereon in this order.

8.   An image sensor according to claim 6, wherein said metal oxide film serves as a dielectric of a charge storage capacitor.

9.   An image sensor according to claim 6, wherein said metal film wiring is composed of a multi-layered film comprising a first metal film consisted of at least one of such metals as Sb, Bi, Hf, Ta, Ti, W, Zr and nitrides thereof, and a second metal film having the higher conductivity than said first metal film.

10.  An image sensor according to claim 6, wherein said thin film photo diode is formed of such material as including amorphous silicon as a base.

# FIG. 1
# PRIOR ART

SHIFT REGISTER ~4

$V_{out}$

## FIG. 3

$V_{out}$

## FIG. 4

# FIG. 5

21 — 21a  21b  21c

16 —

o Vout

8 —

# FIG. 6

101

102

29 —
28 —
22 —
1 —

26
23

27  24  25

## FIG. 7

101

102

29
28
22
1

26
23

27    25 31    24

## FIG. 8

101

102

29
28
22
1

26
23
41

27    24    25